# EUROPÄISCHE PATENTSCHRIFT

(11) **EP 0 687 063 B1**
(45) Veröffentlichungstag und Bekanntmachung des Hinweises auf die Patenterteilung: **23.02.2000**
(21) Anmeldenummer: 95108310.4
(22) Anmeldetag: 30.05.1995
(51) Int. Cl.: H03H 9/64

(54) **Mit akustischen Oberflächenwellen arbeitendes Filter**
Electrical filter operating with acoustical waves
Filtre électrique fonctionnant avec des ondes acoustiques

(30) Priorität: 06.06.1994 DE 4419722
(43) Veröffentlichungstag der Anmeldung: 13.12.1995
(73) Patentinhaber: SIEMENS AKTIENGESELLSCHAFT, 80333 München (DE)
(72) Erfinder: Dill, Roland, Dr. Ing., D-81547 München (DE); Machui, Jürgen, Dr. Phys., D-80809 München (DE)

(56) Entgegenhaltungen:
- DE-A- 4 213 117
- 1993 ULTRASONICS SYMPOSIUM, 31/10-3/11 '93 BALTIMORE (US); M. SOLAL e.a.: A NEW COMPACT SAW LOW LOSS FILTER FOR MOBILE RADIO, P105-109

## Beschreibung

Die vorliegende Erfindung betrifft ein mit akustischen Oberflächenwellen arbeitendes Filter - OFW-Filter - nach dem Oberbegriff des Patentanspruchs 1.

OFW-Filter der gattungsgemäßen Art sind beispielsweise aus der WO 93/08 641 bzw. aus "1993 IEEE Ultrasonics Symposium", Seiten 105 bis 109 bekannt. Bei derartigen Filtern handelt es sich um kleine Filter geringer Verluste, insbesondere für mobile Radioanwendungen. Derartige Filter vereinigen die Vorteile einer geringen Einfügungsdämpfung, einer einfachen Abstimmung, einfacher Herstellbarkeit und geringer Größe, was insbesondere für Mobiltelefone von wesentlicher Bedeutung ist.

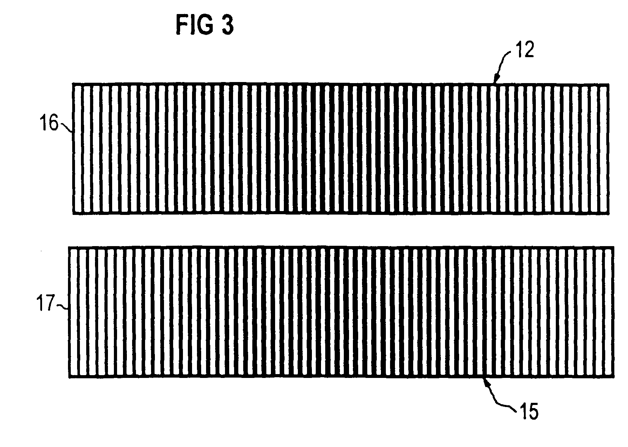

Der generelle Aufbau eines derartigen bekannten OFW-Filters ist in Figur 4 der Zeichnung schematisch dargestellt. Das Filter besitzt zwei akustische Spuren, in denen jeweils ein Eingangswandler 10 bzw. 13, ein Ausgangswandler 11 bzw. 14 und zwischen diesen jeweils eine Reflektorstruktur 12 bzw. 15 angeordnet sind. Die Wandler sind dabei insbesondere als sogenannte SPUDT (Single Phase Unidirectional Transducer) ausgebildet. Ein wesentliches Merkmal eines derartigen Filters besteht darin, daß der Versatz von Spur zu Spur zwischen den Wandlern und dem jeweiligen Reflektor um λ/4 unterschiedlich ist, wobei λ die Wellenlänge bei der Mittenfrequenz des Filters bedeutet. Ein derartiger Versatz ist in Figur 3 dadurch kenntlich gemacht, daß bei einem Abstand X zwischen den Wandlern 10 und 11 und dem Reflektor 12 in der oberen akustischen Spur der entsprechende Abstand in der unteren akustischen Spur X+λ/4 beträgt.

Bei einem derartigen Aufbau beträgt die Phasendifferenz zwischen den beiden Spuren für den direkten Weg zwischen den jeweiligen Wandlern und dem Reflektor 180°. In einer an einen Ausgang A angeschlossenen (nicht dargestellten) Lastimpedanz wird also bei Einspeisung eines elektrischen Eingangssignals in einen Eingang A kein elektrisches Signal erzeugt, wobei sich die Wandler entsprechend ihrem kurzgeschlossenen Zustand verhalten, indem sich lediglich eine sich auslöschende akustische Reflexion ergibt.

Nach Reflexion an den Reflektoren 12, 15 ergibt sich wiederum Phasengleichheit, woraus sich nach Wandlung in den Wandlern ein elektrisches Nutzsignal ergibt.

Weiterhin ergibt sich gemäß Figur 4 ein Doppelweg, der sich aus einer Reflexion an den Reflektoren 12, 15, einer Reflexion an den Wandlern 10, 13 und 11, 14 sowie einer Übertragung durch die Reflektoren 12, 15 zusammensetzt. Ebenso wie beim ersten direkten Weg sind die akustischen Oberflächenwellen in den beiden Spuren gegenphasig, während die an den Reflektoren und an den Ein- und Ausgangswandlern reflektierten akustischen Oberflächenwellen gleichphasig sind.

Durch die Reflexionen an den Ein- und Ausgangswandlern sowie an den Reflektoren ergeben sich zwei zusätzliche Selektionsmechanismen und somit eine Verlängerung der Impulsantwort. Im Vergleich mit einem SPUDT-Filter gleicher Substratlänge kann also mit der beschriebenen Technik eine Verdopplung der Impulsantwortlänge bzw. eine Halbierung der Bandbreite erreicht werden.

Ein Nachteil eines bekannten Filters der vorstehend beschriebenen Art besteht jedoch darin, daß die Auslöschung der direkten Wandler/Wandlersignale nur bei der Filtermittenfrequenz erhalten wird. Es ergibt sich daher nicht nur eine um die Filtermittenfrequenz zentrierte Durchlaßkurve, sondern es entstehen neben dieser Durchlaßkurve auch noch weitere Durchlaßbereiche, die um von der Filtermittenfrequenz verschiedene Frequenzen zentriert sind.

Der vorliegenden Erfindung liegt die Aufgabe zugrunde, ein Filter der in Rede stehenden Art derart weiterzubilden, daß nicht nur bei der Mittenfrequenz eine Auslöschung der direkten Wandler/Wandlersignale vorhanden ist.

Diese Aufgabe wird bei einem OFW-Filter der eingangs genannten Art erfindungsgemäß durch die Merkmale des kennzeichnenden Teils des Patentanspruchs 1 gelöst.

Weiterbildungen der Erfindung sind Gegenstand von Unteransprüchen.

Die Erfindung wird nachfolgend anhand von Ausführungsbeispielen gemäß den Figuren der Zeichnung näher erläutert. Es zeigt:
- Figur 1: eine schematische Darstellung einer Ausführungsform eines erfindungsgemäßen OFW-Filters;
- Figur 2: eine der Figur 1 entsprechende Darstellung einer weiteren Ausführungsform eines erfindungsgemäßen OFW-Filters;
- Figur 3: eine Ausführungsform von Reflektoren für ein OFW-Filter nach Figur 1; und
- Figur 4: die bereits erläuterte schematische Darstellung eines bekannten OFW-Filters.

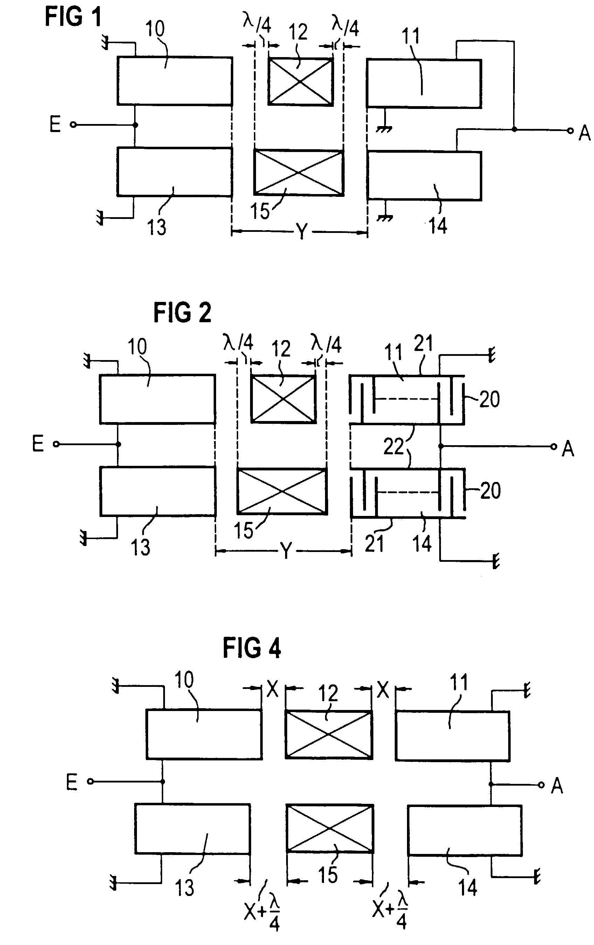

In Figur 1, in der gleiche Teile wie in Figur 4 mit gleichen Bezugszeichen versehen sind, besitzen der jeweilige Eingangswandler 10 bzw. 13 und der jeweilige Ausgangswandler 11 bzw. 14 in den beiden akustischen Spuren den gleichen mit Y bezeichneten Abstand. Weiterhin sind erfindungsgemäß jeweils die Eingangswandler 10, 13 und jeweils die Ausgangswandler 11, 14 in den beiden akustischen Spuren konstruktiv identisch und es sind die Eingangswandler 10, 13 oder die Ausgangswandler 11, 14 elektrisch gegenphasig angeschlossen, während die jeweils anderen Wandler gleichphasig angeschlossen sind. In Figur 1 ist der Fall dargestellt, daß die Eingangswandler 10, 13 gegenphasig und die Ausgangswandler 11, 14 gleichphasig angeschlossen sind. Aus der Darstellung ist dabei ohne weiteres ersichtlich, daß der Anschluß der Wandler auch umgekehrt erfolgen kann.

Bei der Ausführungsform nach Figur 2, in der gleiche Teile wie in Figur 1 mit gleichen Bezugszeichen versehen sind, wird die Gleich- bzw. Gegenphasigkeit dadurch erreicht, daß bei wiederum konstruktiv identischen Wandlern 10, 11, 13, 14 die Wandler 11, 14 auf der Ausgangsseite gegenseitig zueinander angeordnet sind. Dies ist schematisch dadurch kenntlich gemacht, daß interdigital angeordnete Elektrodenfinger 20 jeweils gegensinnig von Sammelschienen 21, 22 ausgehen.

Erfindungsgemäß ist weiterhin vorgesehen, daß die Reflektorstrukturen 12, 15 im wesentlichen gleiches Reflexionsverhalten besitzen und die Reflektorstruktur in der einen Spur - im Fall der Ausführungsformen nach den Figuren 1 und 2 die Reflektorstruktur 12 - gegenüber der Reflektorstruktur in der anderen Spur - im Fall der Ausführungsformen nach den Figuren 1 und 2 die Reflektorstruktur 15 - um λ/2 kürzer ist. Bei den in den Figuren 1 und 2 dargestellten Anordnungen ist die Reflektorstruktur 12 auf sich gegenüberliegenden Seiten jeweils um λ/4 kürzer als die Reflektorstruktur 15, was dadurch gegeben ist, daß die beiden Reflektorstrukturen 12, 15 in den beiden Spuren erfindungsgemäß mittig zwischen den jeweiligen Wandlern 10, 11 bzw. 13, 14 angeordnet sind.

In Weiterbildung der Erfindung sind Wandler 10, 11, 13, 14 vorzugsweise als SPUDT-Wandler ausgebildet.

In weiterer Ausgestaltung der Erfindung sind die Reflektorstrukturen 12, 15 gewichtete Reflektorstrukturen, wobei die Wichtung durch Breitenänderung, Positionsverschiebung, Breitenänderung und Positionsverschiebung oder durch Weglassen von Elektrodenstreifen in den Reflektorstrukturen erfolgen kann.

Figur 3 zeigt eine Ausführungsform der Reflektorstrukturen 12 und 15 nach den Figuren 1 und 2 in Form von Reflektoren mit kurzgeschlossenen Elektrodenstreifen 16 bzw. 17 und Wichtung der Reflektoren durch Breitenänderung der Elektrodenstreifen. Der Einfachheit halber ist in Figur 2 jeweils nur ein Elektrodenstreifen einer Vielzahl von Elektrodenstreifen mit 16 bzw. 17 bezeichnet.

Ein erfindungsgemäßes OFW-Filter besitzt die Vorteile attraktiver Realisierungsmöglichkeiten mit niedriger Einfügungsdämpfung bei einfachem Design und genauer Analyse, sehr hoher Selektion, sehr geringem Übersprechen, Volumenwellenunterdrückung und Möglichkeit des Verzichtes auf eine Koppelspule zwischen den akustischen Spuren.

## Patentansprüche

1. Mit akustischen Oberflächenwellen arbeitendes Filter mit zwei akustischen Spuren, in denen jeweils ein unidirektionaler Eingangswandler (10, 13), ein unidirektionaler Ausgangswandler (11, 14) und zwischen diesen eine Reflektorstruktur (12, 15) angeordnet sind,
**dadurch gekennzeichnet,**
daß jeweils die Eingangswandler (10, 13) und jeweils die Ausgangswandler (11, 14) in den akustischen Spuren konstruktiv identisch sind und die Eingangs- und Ausgangswandler (10, 11, 13, 14) in den akustischen Spuren gleichen Abstand (Y) besitzen, daß entweder die Eingangswandler (10, 13) oder die Ausgangswandler (11, 14) elektrisch gegenphasig angeschlossen sind, während die jeweils anderen Wandler gleichphasig angeschlossen sind, und daß die Reflektorstruktur (12, 15) der beiden akustischen Spuren im wesentlichen gleiches Reflexionsverhalten besitzen, die Reflektorstruktur (12) in der einen akustischen Spur gegenüber der Reflektorstruktur (15) in der anderen akustischen Spur um λ/2 kürzer ist und die Reflektorstrukturen (12, 15) in den beiden akustischen Spuren mittig zwischen den Wandlern (10, 11, 13, 14) angeordnet sind, wobei λ die Wellenlänge bei Filtermittenfrequenz bedeutet.

2. Filter nach Anspruch 1,
**dadurch gekennzeichnet,** daß die Wandler (10, 11, 13, 14) als SPUDT-Wandler ausgebildet sind.

3. Filter nach Anspruch 1 und/oder 2,
**dadurch gekennzeichnet,** daß die Reflektorstrukturen (12, 15) durch Breitenänderung von Elektrodenstreifen (16, 17) gewichtete Strukturen sind.

4. Filter nach Anspruch 1 und/oder 2,
**dadurch gekennzeichnet,** daß die Reflektorstrukturen (12, 15) durch Positionsverschiebung von Elektrodenstreifen (16, 17) gewichtete Strukturen sind.

5. Filter nach Anspruch 1 und/oder 2,
**dadurch gekennzeichnet,** daß die Reflektorstrukturen (12, 15) durch Kombination von Breitenänderung und Positionsverschiebung von Elektrodenstreifen (16, 17) gewichtete Strukturen sind.

6. Filter nach Anspruch 1 und/oder 2,
**dadurch gekennzeichnet,** daß die Reflektorstrukturen (12, 15) durch Weglassen von Elektrodenstreifen (16, 17) gewichtete Strukturen sind.

## Claims

1. Filter operating with surface acoustic waves having two acoustic tracks, in each of which a unidirectional input transducer (10, 13), a unidirectional output transducer (11, 14) and, between them, a reflector structure (12, 15) are arranged, **characterized in that** each input transducer (10, 13) and each output transducer (11, 14) in the acoustic tracks are of identical design, and the input and output transducers (10, 11, 13, 14) in the acoustic tracks are at the same separation (Y), in that either the input transducers (10, 13) or the output transducers (11, 14) are electrically connected in antiphase, while the other respective transducers are connected in phase, and in that the reflector structures (12, 15) of the two acoustic tracks have essentially the same reflection response, the reflector structure (12) in one acoustic track being shorter by λ/2 than the reflector structure (15) in the other acoustic track, and the reflector structures (12, 15) in the two acoustic tracks being arranged centrally between the transducers (10, 11, 13, 14), λ being the wavelength at the central filter frequency.

2. Filter according to Claim 1, **characterized in that** the transducers (10, 11, 13, 14) are designed as SPUDT transducers.

3. Filter according to Claim 1 and/or 2, **characterized in that** the reflector structures (12, 15) are structures weighted by width variation of electrode strips (16, 17).

4. Filter according to Claim 1 and/or 2, **characterized in that** the reflector structures (12, 15) are structures weighted by position shifting of electrode strips (16, 17).

5. Filter according to Claim 1 and/or 2, **characterized in that** the reflector structures (12, 15) are structures weighted by a combination of width variation and position shifting of electrode strips (16, 17).

6. Filter according to Claim 1 and/or 2, **characterized in that** the reflector structures (12, 15) are structures weighted by omission of electrode strips (16, 17).

## Revendications

1. Filtre fonctionnant avec des ondes de surface acoustiques ayant deux pistes acoustiques, dans lesquelles sont agencés chaque fois un transducteur d'entrée unidirectionnel (10, 13), un transducteur de sortie unidirectionnel (11, 14) et, entre ceux-ci, une structure à réflecteur (12, 15),
**caractérisé en ce que**
chaque fois les transducteurs d'entrée (10, 13) et chaque fois les transducteurs de sortie (11, 14) dans les pistes acoustiques sont structurellement identiques et les transducteurs d'entrée et de sortie (10, 11, 13, 14) dans les pistes acoustiques possèdent la même distance (Y), en ce que soit les transducteurs d'entrée (10, 13) soit les transducteurs de sortie (11, 14) sont connectés électriquement en opposition de phase, alors que, chaque fois, les autres transducteurs sont connectés en équiphase, et en ce que la structure à réflecteur (12, 15) des deux pistes acoustiques possède essentiellement un comportement à la réflexion identique, la structure à réflecteur (12) dans l'une des pistes acoustiques est inférieure de λ/2 vis-à-vis de la structure à réflecteur (15) dans l'autre piste acoustique, et les structures à réflecteur (12, 15) dans les deux pistes acoustiques sont agencées de manière centrale entre les transducteurs (10, 11, 13, 14), λ signifiant la longueur d'onde dans la fréquence centrale du filtre.

2. Filtre suivant la revendication 1,
**caractérisé en ce que** les transducteurs (10, 11, 13, 14) sont conçus comme des transducteurs SPUDT.

3. Filtre suivant la revendication 1 et/ou 2,
**caractérisé en ce que** les structures à réflecteur (12, 15) sont des structures pondérées par modification de largeur des bandes d'électrodes (16, 17).

4. Filtre suivant la revendication 1 et/ou 2,
**caractérisé en ce que** les structures à réflecteur (12, 15) sont des structures pondérées par décalage de position des bandes d'électrodes (16, 17).

5. Filtre suivant la revendication 1 et/ou 2,
**caractérisé en ce que** les structures à réflecteur (12, 15) sont des structures pondérées par combinaison de la modification de largeur et du décalage de position des bandes d'électrodes (16, 17).

6. Filtre suivant la revendication 1 et/ou 2,
**caractérisé en ce que** les structures à réflecteur (12, 15) sont des structures pondérées par suppression des bandes d'électrodes (16, 17).
